# EUROPEAN PATENT SPECIFICATION

(11) **EP 3 332 271 B1**
(45) Date of publication and mention of the grant of the patent: **25.09.2024**
(21) Application number: 16758315.2
(22) Date of filing: 03.08.2016
(51) Int. Cl.: G01T 1/24

(54) **APPARATUS AND METHODS TO DETECT SEMICONDUCTOR DEVICE DEGRADATION DUE TO RADIATION EXPOSURE**
VORRICHTUNG UND VERFAHREN ZUR DETEKTION DES HALBLEITERBAUELEMENTEZERFALLS DURCH STRAHLENEXPOSITION
APPAREIL ET PROCÉDÉS DE DÉTECTION DE DÉGRADATION DE DISPOSITIF À SEMI-CONDUCTEURS PAR EXPOSITION À DES RAYONNEMENTS

(30) Priority: 03.08.2015 US 201514816298
(43) Date of publication of application: 13.06.2018
(73) Proprietor: Fisher Controls International LLC, Marshalltown, IA 50158 (US)
(72) Inventor: WITTKOP, Adam Joseph, Marshalltown, IA 50158 (US)
(74) Representative: Petraz, Gilberto Luigi
(86) International application number: PCT/US2016/045225
(87) International publication number: WO 2017/023960

(56) References cited:
- WO-A1-2012/143693
- KR-A- 20040 019 439
- US-A- 2 975 286
- US-A- 2 975 286
- US-A1- 2009 189 082
- US-A1- 2009 189 082
- US-A1- 2013 334 897

## Description

### FIELD OF THE DISCLOSURE

This disclosure relates generally to radiation exposure detection and, more particularly, to apparatus and methods to detect semiconductor device degradation due to radiation exposure.

### BACKGROUND

Analog circuits are widely used in process control systems. Measurements from analog circuits are often a critical part of a process control system. In some process control environments, analog circuits are exposed to radiation, which can degrade the semiconductor devices used to implement the circuits to the point of failure. As the cumulative exposure to radiation increases, an output of an analog circuit may drift and/or a frequency response of the circuit degrades until the process control system can no longer compensate for the errors resulting from the degradation. Detection of analog circuit degradation before the degradation adversely affects the measurements from the analog circuit enables an operator to take action to keep the process under control. For example, if degradation of an analog circuit associated with a sensor due to radiation is detected, a positioner or controller that uses the sensor for control feedback may switch to a different control mode and ignore the feedback from the analog circuit to which the sensor is coupled. Document US 2009/0189082 A1 describes known method and apparatus for radiation effects detection. Known means for radiation detection are also described in document US 2975286 A. A hybrid semiconductor type radiation detector is described in the document KR 20040019439 A. Document US 2013/334897 A1 discloses an integrated circuit with automatic total ionizing dose exposure deactivation. Document WO 2012/143693 A1 describes apparatus and methods for fluid processing and flow control.

### SUMMARY

The invention relates to a method according to claim 7.

The invention relates to an apparatus according to claim 1.

Another example apparatus that does not form part of the present invention includes an analog circuit having a first integrated circuit, a reference circuit having a second integrated circuit identical to the first integrated circuit, where the reference circuit provides a feedback signal, the feedback signal indicative of degradation of the reference circuit and the analog circuit, and a process control device to monitor the feedback signal from the reference circuit.

### BRIEF DESCRIPTION OF THE DRAWINGS

FIG. 1 is a diagram of an example apparatus that may be implemented to detect degradation of a circuit due to radiation exposure.
FIG. 2 is a diagram of an example positioner that may be implemented with the example apparatus of FIG. 1.
FIG. 3 is an example radiation degradation curve that may be associated with the example apparatus and methods described herein.
FIG. 4 is a diagram of another example apparatus that does not form part of the present invention that may be implemented to detect degradation of a circuit due to radiation exposure.
FIG. 5 is an example method that may be performed to implement the example apparatus described herein.
FIG. 6 is another example method that may be performed to implement the example apparatus described herein, useful for understanding the invention.
FIG. 7 is an example diagram of a processor platform which may be used to implement examples disclosed herein and useful for understanding the invention.

### DETAILED DESCRIPTION

The example apparatus and methods described herein may be implemented to predict and detect degradation and failure of semiconductor devices within analog circuits due to radiation exposure. The example apparatus and methods may be used in a process control environment or in any other environment.

Some examples described herein include a semiconductor device, such as an operational amplifier, having a known degradation characteristic due to radiation exposure. As the cumulative amount of radiation exposure (e.g., radiation dose) increases, the current consumption of the semiconductor device changes in a predictable way. This change may follow a degradation curve associated with the semiconductor. In some examples, the rate of degradation is variable and the total radiation dose to which the semiconductor has been exposed affects how quickly the measured current of the semiconductor decreases.

In an example described herein, a semiconductor device is coupled to a positioner that measures a current supplied to the semiconductor device and, using the degradation curve, correlates the measured current with a radiation dose. The positioner compares the radiation dose to a predetermined threshold based on the degradation curve of the semiconductor to detect when the radiation dose reaches a radiation dose threshold. To enable the operation of the example apparatus, the positioner may include a memory to store the data and the degradation curve, a communication interface to receive data and send alarms, and a processor to compare the measured supply current to the degradation curve.

The radiation dose threshold is defined by the degradation curve and corresponds to an amount of radiation exposure that causes the circuit being monitored to degrade or fail. When the radiation dose reaches the radiation dose threshold, the positioner may send an alert to an operator workstation indicating that a circuit (e.g., an analog circuit associated with a feedback sensor) coupled to the positioner may be degrading or is close to failure. Additionally, if the radiation dose is within a range of the radiation dose threshold, degradation or failure of the circuit is likely to occur and the processor sends an alarm to the operator workstation.

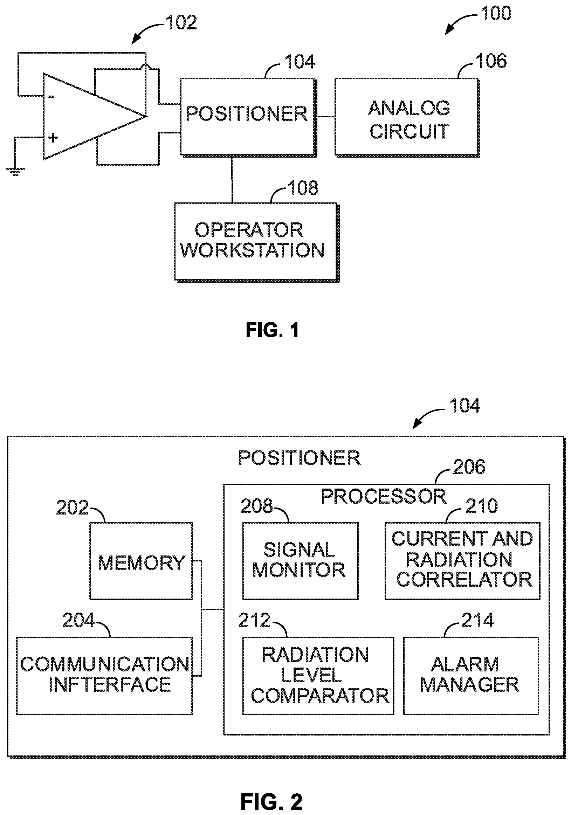

FIG. 1 is a block diagram of an example apparatus 100 that may be implemented to detect degradation or failure of a circuit due to radiation exposure. The example apparatus 100 includes an example semiconductor device 102 that acts as a radiation exposure monitor that indicates an amount of radiation (e.g., a radiation dose) to which the example apparatus 100 has been exposed. The example semiconductor device 102 may be implemented as an operational amplifier (as shown in FIG. 1), a transistor, a diode or any other electrical circuit component with a known degradation curve due to radiation exposure. A supply current of the semiconductor device 102 may be measured by a positioner 104 (which in the presently claimed invention is a process control device) coupled to the semiconductor device 102. The known degradation curve associated with the semiconductor device 102 correlates a measured current of the semiconductor device 102 with an amount of radiation to which the semiconductor device 102 has been exposed. As the amount of radiation exposure increases, the current of the semiconductor device 102 changes in a predictable way as described, for example, by a degradation curve associated with the semiconductor device 102. For example, the supply current of the semiconductor device 102 may decrease due to the increase of radiation exposure.

The semiconductor device 102 may be selected based on the analog circuit used in the example apparatus 100. The analog circuit 106 (e.g., a process control circuit) may be used to perform a variety of functions in a process control system, such as measuring parameters, operating process control components, and/or communicating data to the positioner 104. The semiconductor device 102 may be selected in accordance with the amount of radiation the analog circuit 106 can withstand. For example, the semiconductor device 102 may be selected such that the radiation dose threshold defined by the degradation curve corresponds to an amount of radiation the analog circuit 106 of the example apparatus 100 can withstand prior to degradation or failure. Thus, in one such example, if the analog circuit 106 associated with the semiconductor device 102 can withstand 200,000 radiation absorbed doses (i.e., 200 krads) of radiation exposure, the selected semiconductor device 102 may be a radiation hardened operational amplifier that has been tested for performance up to 200 krads of radiation exposure. In some examples, the semiconductor device 102 may be selected such that the semiconductor device 102 is operative to warn the operator of the potential circuit failure by a reaching a threshold current defined by the degradation curve, but the semiconductor device 102 remains operable throughout operation of the example apparatus 100. In other examples, the analog circuit 106 may be tolerant of a different amount of radiation exposure and, thus, the selected semiconductor device 102 may be able to withstand a different amount of radiation.

In some examples, redundant or multiple semiconductor devices 102 may be used to ensure the detection of radiation exposure is accurate and not a false detection in response to a degradation or failure of the semiconductor device 102 due to another reason such as, for example, a voltage surge or spike. The current measurements from the multiple semiconductor devices 102 may be polled or compared to detect if one of the semiconductor devices 102 may be failing in response to something other than radiation exposure. In some examples, all of the semiconductor devices 102 are the same type and the current measurements of the semiconductor devices 102 may be averaged prior to comparison with the degradation curve associated with the semiconductor devices 102. In other examples, an outlying current measurement may be determined while comparing the measurements from the multiple semiconductor devices 102 and, if an outlying current measurement exists, that measurement may be disregarded. Alternatively, each of the semiconductor devices 102 may be rated to withstand a different radiation dose and compared to corresponding degradation curves.

The semiconductor device 102 may be implemented in the example apparatus 100 solely to act as a radiation exposure detection device for the example apparatus 100, including the analog circuit 106. In other examples, the semiconductor device 102, in addition to acting as a radiation exposure monitor, may also function in a manner consistent with the intended application of the semiconductor device 102. For example, if the semiconductor device 102 is an operational amplifier, then the semiconductor device 102 may also perform an amplification function.

The semiconductor device 102 is coupled to the example positioner 104, which may be a digital valve controller similar to those used in process control systems. However, in some examples, other types of positioners 104, which are configured to control a position of a valve, may be used instead. In some examples, the semiconductor device 102 may be integrated within the positioner 104. In other examples, the semiconductor device 102 is separate from the positioner 104 and the positioner 104 may monitor the semiconductor device 102 remotely. The positioner 104 may also be operatively coupled to the analog circuit 106 and an operator workstation 108. The positioner 104 can send alerts and alarms to the operator workstation 108 and receive messages, data and commands from the operator workstation 108. The operator workstation 108 may be a computer, a handheld device, or any other device capable of sending and receiving messages, data and commands. A more detailed depiction of the example positioner 104 described herein is shown and described in connection with FIG. 2.

As depicted in FIG. 2, the example positioner 104 includes a memory 202, a communication interface 204, and a processor 206. The memory 202 may be any type of tangible computer readable storage device or storage disk. The memory 202 is used to store, temporarily or permanently, any data that is used to determine the radiation dose to which the example apparatus 100 is exposed. For example, the degradation curve associated with the semiconductor device 102, any measurements associated with the semiconductor device 102 such as, for example, the measured current, and any values determined or used during the process of detecting the radiation dose to which the example apparatus 100 is exposed.

The communication interface 204 is operative to receive the current from the semiconductor device 102, which is measured by the processor 206, and send alarms to the operator workstation 108 (FIG. 1). Other data relating to an operation or status of the example apparatus 100, such as process control data and commands, may also be communicated through the communication interface 204.

The processor 206 monitors and measures the total current flowing through the semiconductor device 102 via a signal monitor 208. Once the current is measured, the processor 206 accesses the degradation curve from the memory 202 and compares the measured current to the degradation curve to correlate the measured current with the radiation dose via a current and radiation correlator 210. The processor 206 may also determine the radiation dose threshold using the degradation curve. The radiation dose threshold may be associated with an amount of radiation exposure that causes the analog circuit 106 to degrade to a level of performance that is deemed unacceptable. The radiation dose threshold may correspond to a point on the degradation curve at which the radiation dose is high enough to render the semiconductor device 102 device inoperable for its purpose. The processor 206 uses the determined radiation dose of the example apparatus 100 and compares that amount to the radiation dose threshold to determine if the radiation dose has reached the radiation dose threshold via a radiation level comparator 212. If the radiation dose has reached the radiation dose threshold, an alarm manager 214 of the processor 206 may send an alarm or alert to the operator workstation 108 operatively coupled to the positioner 104, alerting an operator of the possible degradation or failure of the analog circuit 106. If the radiation dose is within a range of the radiation dose threshold, degradation or failure of the analog circuit is likely to occur and the alarm manager 214 sends an alarm to the operator workstation 108 indicating the likelihood of degradation or failure of the analog circuit 106. Sending an alert to the operator workstation 108 indicating potential failure of the circuit 106 enables an operator to take action to prevent the failure of the analog circuit 106 from affecting the process control system. For example, in response to receiving the alert, the operator may change the operating mode of the process control system. In other examples, the operator may replace or repair the components of the affected circuit 106.

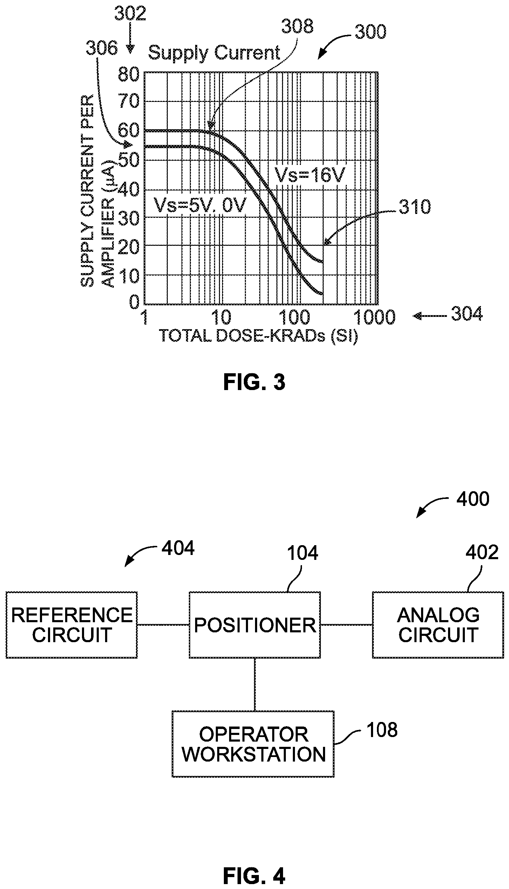

FIG. 3 depicts an example radiation degradation curve 300 that may be associated with the semiconductor device 102 of the example apparatus 100 described herein. The example degradation curve 300 of FIG. 3 correlates a supply current 302 of the semiconductor device 102 with a total dose 304 of radiation exposure. In this example, the degradation curve 300 is associated with a radiation hardened micropower dual operational amplifier.

The example degradation curve 300 has an initial current 306 when the total dose 304 is small (e.g., less than 5 krads). The supply current 302 begins to decrease when the total dose 304 reaches a deterioration dose 308. The supply current 302 continues to decrease until the supply current 302 is no longer sufficient to operate the semiconductor device 102. The total dose 304 when the supply current 302 becomes inoperable is the degradation point 310 of the semiconductor device 102, and may also be the radiation dose threshold defined by the degradation curve 300. In some examples, another point of the degradation curve 300 may be selected to be the radiation dose threshold. The example degradation curve 300 of FIG. 3 depicts curves for two different supply voltages, but other degradation curves may exist.

FIG. 4 is a block diagram of another example apparatus 400 that does not form part of the present invention and that may be implemented to detect degradation or failure of a circuit due to radiation exposure. The example apparatus 400 of FIG. 4 may be implemented if a semiconductor device having a known degradation due to radiation is not available or the degradation of an available semiconductor devices does not correspond with the degradation of an analog circuit 402. The analog circuit 402 may perform one or more primary functions of the apparatus 400. In some examples, the primary function performed by the analog circuit 402 may include amplifying a bridge resistance of a Hall Effect sensor circuit.

The example apparatus 400 includes a reference circuit 404 that may be used to detect degradation due to radiation. The reference circuit 404 may be similar to the analog circuit 402 and, thus, may contain similar and/or identical components. For example, the reference circuit may contain at least one integrated circuit (e.g., an operational amplifier) identical to at least one integrated circuit of the analog circuit. In some examples, the reference circuit 404 may be implemented to provide a feedback signal (e.g., a current signal or a voltage signal) to the positioner 104 via the communication interface 204 to monitor the reference circuit 404 and/or the analog circuit 402 for degradation due to radiation. In some examples, the signal from the reference circuit 404 to the positioner 104 may include an amplified signal from a fixed resistive bridge. Thus, the signal from the reference circuit 404 is substantially affected only by degradation due to radiation and not by the fluctuations of the parameter being measured by the analog circuit 402. As a result, the signal to the positioner 104 from the reference circuit 404 indicates when the reference circuit 404 and, thus, the analog circuit 402, may be experiencing degradation due to radiation. Specifically, the reference circuit 404 is to provide a fixed signal output (e.g., a constant voltage or current) due to the fixed bridge resistance to which it is coupled. If the reference circuit 404 is exposed to radiation, an operational amplifier, for example, within the reference circuit 404 may degrade, whereas the bridge resistance to which the reference circuit 404 is coupled will not be affected in any meaningful way by the radiation. However, the degradation of the operational amplifier causes a change in the signal output of the reference circuit, thereby indicating an amount of degradation.

If the signal monitor 206 of the positioner 104 detects that the signal from the reference circuit 404 has degraded, the alarm manager 214 of the positioner 104 can send alerts and alarms to the operator workstation 108 and receive messages, data and commands from the operator workstation 108. To detect that the signal from the reference circuit has degraded, the positioner may compare a variance of the feedback signal from the reference circuit 404 to a variation threshold. A change in the feedback signal beyond the variation threshold may indicate that the analog circuit 402 and/or the reference circuit 404 is experiencing degradation. The variation threshold may be selected by the operator. The variance of the feedback signal may be determined by comparing an initial value of the feedback signal to a current value of the feedback signal.

The example positioner 104 and/or processor 206 of FIGS. 1-2 and 4 may be implemented by any combination of hardware, software and/or firmware. Thus, for example, the example positioner 104 and/or processor 206 could be implemented by one or more analog or digital circuit(s), logic circuits, programmable processor(s), application specific integrated circuit(s) (ASIC(s)), programmable logic device(s) (PLD(s)) and/or field programmable logic device(s) (FPLD(s)). When reading any of the apparatus or method claims of this patent to cover a purely software and/or firmware implementation, the example positioner 104 and/or processor 206 are hereby expressly defined to include a tangible computer readable storage device or storage disk such as a memory, a digital versatile disk (DVD), a compact disk (CD), a Blu-ray disk, etc. storing the software and/or firmware. Further still, the example positioner 104 and/or processor 206 of FIGS. 1-2 and 4 may include one or more elements, processes and/or devices and/or may include more than one of any or all of the elements, processes and devices.

Additionally, the example positioner 104 and/or processor 206 of FIGS. 1-2 and 4 may communicate with one or more of the components (e.g., the semiconductor device 102, the analog circuit 106 and/or 402, the operator workstation 108, the reference circuit 404, etc.) using any type of wired connection (e.g., a databus, a USB connection, etc.) or a wireless communication mechanism (e.g., radio frequency, infrared, etc.) using any past, present or future communication protocol (e.g., Bluetooth, USB 2.0, USB 3.0, etc.). Further, one or more components of FIGS. 1-2 and 4 may communicate with each other using such wired connection or wireless communication mechanisms.

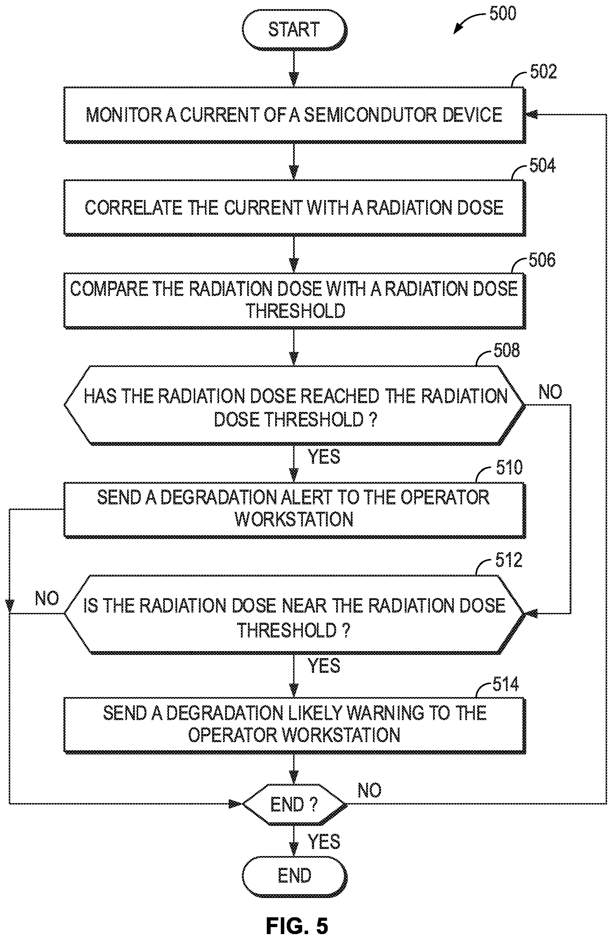

FIG. 5 depicts an example method 500 that may be implemented with the example apparatus 100 described herein. The example method 500 begins with the signal monitor 208 of the processor 206 monitoring and/or measuring the current of the semiconductor device 102 (block 502). The current and radiation correlator 210 of the processor 206 uses the degradation curve 300 to correlate the measured current with the radiation dose (block 504). The radiation level comparator 212 compares the radiation dose to the radiation dose threshold (block 506). The processor 206 then determines if the radiation dose has reached the radiation dose threshold (block 508). If the radiation dose has reached the radiation dose threshold, the alarm manager 214 sends an alarm or alert to the operator workstation 108 to alert the operator of the degradation or failure of the analog circuit 106 (block 510). If the radiation dose has not reached the radiation dose threshold, the processor 206 determines if the radiation dose is within a range of the radiation dose threshold (block 512). If the radiation dose is within a range (e.g., within 10 krads) of the radiation dose threshold, the alarm manager 214 sends an alert or alarm to the operator workstation 108 (block 514). If the radiation dose is not within the range of the radiation dose threshold, the signal monitor 208 may continue monitoring the current of the semiconductor device 102 (block 502) or the process of detecting circuit failure due to radiation may conclude.

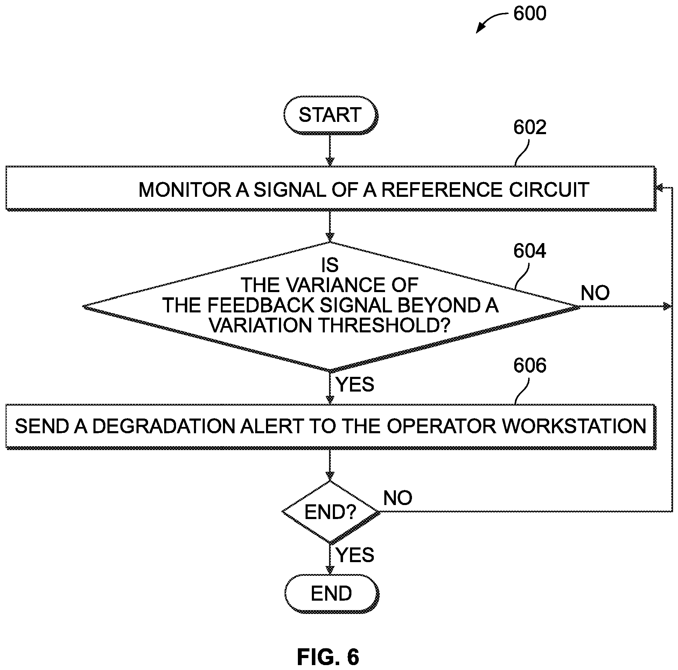

FIG. 6 depicts an example method 600 that may be implemented with the example apparatus 400 described herein. The example method 600 begins with the signal monitor 208 of the processor 206 of the positioner 104 monitoring and/or measuring the signal output by the reference circuit 404 (block 602). The processor 206 then determines if the signal output by the reference circuit 404 has degraded due to radiation by comparing a variance of the feedback signal from the reference circuit 404 to a variation threshold (block 604). If the signal output by the reference circuit 404 has degraded due to radiation, the alarm manager 214 sends an alarm or alert to the operator workstation 108 to alert the operator of the degradation or failure of the analog circuit 402 (block 606). If the signal of the reference circuit has not been affected due to radiation exposure, the signal monitor 208 may continue monitoring the signal output by the reference circuit 404 (block 602) or the process of detecting circuit failure due to radiation may conclude.

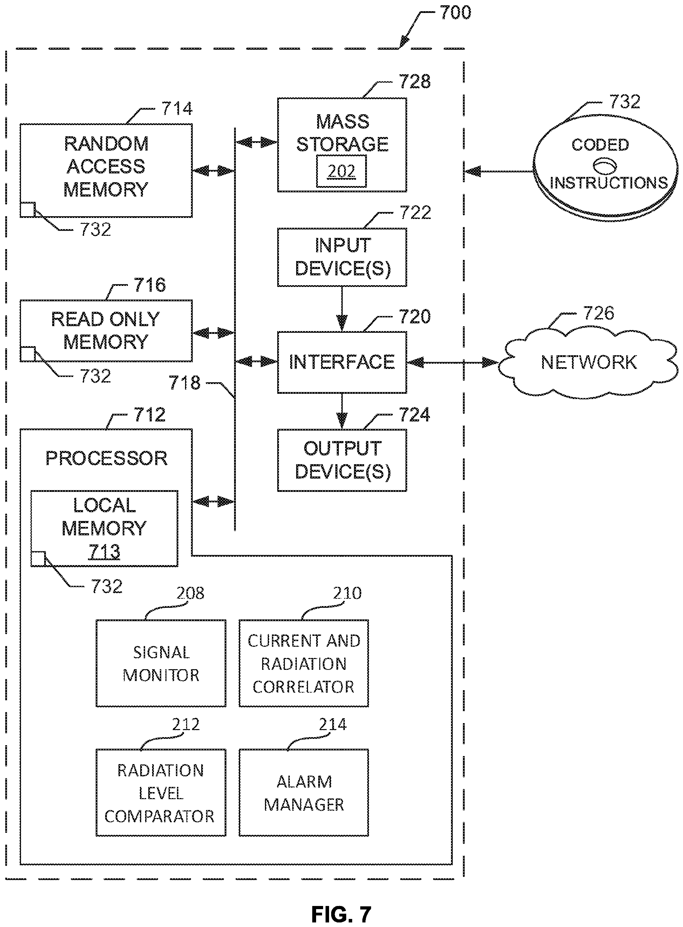

In the described examples, at least a portion of the example methods 500 and 600 represented by the flowcharts in FIGS. 5 and 6 may be implemented using machine readable instructions that comprise a program for execution by a processor such as the processor 712 shown in the example processor platform 700 discussed below in connection with FIG. 7. The program may be embodied in software stored on a tangible computer readable storage medium such as a CD-ROM, a floppy disk, a hard drive, a digital versatile disk (DVD), a Blu-ray disk, or a memory associated with the processor 712, but the entire program and/or parts thereof could alternatively be executed by a device other than the processor 712 and/or embodied in firmware or dedicated hardware. Further, although the example program is described with reference to the flowcharts illustrated in FIGS. 5 and 6, many other methods of implementing the example apparatus described herein may alternatively be used. For example, the order of execution of the blocks may be changed, and/or some of the blocks described may be changed, eliminated, or combined.

As mentioned above, at least a portion of the example methods 500 and 600 of FIGS. 5 and 6 may be implemented using coded instructions (e.g., computer and/or machine readable instructions) stored on a tangible computer readable storage medium such as a hard disk drive, a flash memory, a read-only memory (ROM), a compact disk (CD), a digital versatile disk (DVD), a cache, a random-access memory (RAM) and/or any other storage device or storage disk in which information is stored for any duration (e.g., for extended time periods, permanently, for brief instances, for temporarily buffering, and/or for caching of the information). As used herein, the term tangible computer readable storage medium is expressly defined to include any type of computer readable storage device and/or storage disk and to exclude propagating signals and to exclude transmission media. As used herein, "tangible computer readable storage medium" and "tangible machine readable storage medium" are used interchangeably. Additionally or alternatively, the example method of FIG. 4 may be implemented using coded instructions (e.g., computer and/or machine readable instructions) stored on a non-transitory computer and/or machine readable medium such as a hard disk drive, a flash memory, a read-only memory, a compact disk, a digital versatile disk, a cache, a random-access memory and/or any other storage device or storage disk in which information is stored for any duration (e.g., for extended time periods, permanently, for brief instances, for temporarily buffering, and/or for caching of the information). As used herein, the term non-transitory computer readable medium is expressly defined to include any type of computer readable storage device and/or storage disk and to exclude propagating signals and to exclude transmission media.

FIG. 7 is a block diagram of an example processor platform 700 capable of executing instructions to implement at least a portion of the methods of FIGS. 5 and 6. The processor platform 700 can be, for example, a server, a personal computer, a mobile device (e.g., a cell phone, a smart phone, a tablet such as an iPad^{™}), a personal digital assistant (PDA), an Internet appliance or any other type of computing device.

The processor platform 700 of the illustrated example includes a processor 712. The processor 712 of the illustrated example is hardware. For example, the processor 712 can be implemented by one or more integrated circuits, logic circuits, microprocessors or controllers from any desired family or manufacturer. The processor 712 may correspond to the processor 206 and/or may include the signal monitor 208, the current and radiation correlator 210, the radiation level comparator 212 and the alarm manager 214.

The processor 712 of the illustrated example includes a local memory 713 (e.g., a cache). The processor 712 of the illustrated example is in communication with a main memory including a volatile memory 714 and a non-volatile memory 716 via a bus 718. The volatile memory 714 may be implemented by Synchronous Dynamic Random Access Memory (SDRAM), Dynamic Random Access Memory (DRAM), RAMBUS Dynamic Random Access Memory (RDRAM) and/or any other type of random access memory device. The non-volatile memory 716 may be implemented by flash memory and/or any other desired type of memory device. Access to the main memory 714, 716 is controlled by a memory controller.

The processor platform 700 of the illustrated example also includes an interface circuit 720. The interface circuit 720 may be implemented by any type of interface standard, such as an Ethernet interface, a universal serial bus (USB), and/or a PCI express interface.

In the illustrated example, one or more input devices 722 are connected to the interface circuit 720. The input device(s) 722 permit(s) a user to enter data and commands into the processor 712. The input device(s) 722 can be implemented by, for example, an audio sensor, a microphone, a camera (still or video), a keyboard, a button, a mouse, a touchscreen, a track-pad, a trackball, isopoint and/or a voice recognition system.

One or more output devices 724 are also connected to the interface circuit 720 of the illustrated example. The output devices 724 can be implemented, for example, by display devices (e.g., a light emitting diode (LED), an organic light emitting diode (OLED), a liquid crystal display, a cathode ray tube display (CRT), a touchscreen, a tactile output device, a printer and/or speakers). The interface circuit 720 of the illustrated example, thus, typically includes a graphics driver card, a graphics driver chip or a graphics driver processor.

The interface circuit 720 of the illustrated example also includes a communication device such as a transmitter, a receiver, a transceiver, a modem and/or network interface card to facilitate exchange of data with external machines (e.g., computing devices of any kind) via a network 726 (e.g., an Ethernet connection, a digital subscriber line (DSL), a telephone line, coaxial cable, a cellular telephone system, etc.).

The processor platform 700 of the illustrated example also includes one or more mass storage devices 728 for storing software and/or data. Examples of such mass storage devices 728 include floppy disk drives, hard drive disks, compact disk drives, Blu-ray disk drives, RAID systems, and digital versatile disk (DVD) drives. The mass storage device may additionally include the memory 202.

Coded instructions 732 to implement at least a portion of the methods 500 and 600 of FIGS. 5 and 6 may be stored in the mass storage device 728, in the volatile memory 714, in the non-volatile memory 716, and/or on a removable tangible computer readable storage medium such as a CD or DVD.

## Claims

1. An apparatus comprising:
a semiconductor device (102) in an analog circuit (106) for a process control system, the semiconductor device (102) having a known degradation in response to radiation exposure; and
a process control device (104) configured to control a position of a valve within the process control system, the process control device coupled to the semiconductor device (102) and including a memory (202), a communication interface (204), and a processor (206), the process control device (104) being configured to:
monitor, via the processor (206), a supply current of the semiconductor device (102);
correlate, via the processor (206), the supply current with a cumulative amount of radiation exposure;
compare, via the processor (206), the amount of radiation exposure to a radiation dose threshold, the radiation dose threshold derived from the known degradation and corresponding to an amount of radiation at which the semiconductor device (102) degrades; and
send, via the communication interface (204), an alert to an operator workstation (108) when degradation is indicated based on the comparison to prevent the failure of the analog circuit (106) from affecting the process control system.

2. The apparatus of claim 1, wherein the known degradation of the semiconductor device (102) follows a degradation curve, wherein the radiation dose threshold is defined by the degradation curve or correlates a decrease of the supply current of the semiconductor device (102) with an increase in the cumulative amount of radiation exposure.

3. The apparatus of any of claims 1 or 2, wherein the process control device (104) is configured to detect that the semiconductor device (102) has degraded based on the comparison.

4. The apparatus of any of the preceding claims, wherein the semiconductor device (102) is integrated in the process control device (104) or is a radiation hardened micropower dual operational amplifier.

5. The apparatus of claim 1, wherein the process control device (104) is further configured to detect that the amount of radiation exposure is approaching the radiation dose threshold and send a warning to the operator workstation (108).

6. The apparatus of claim 1, wherein the process control device (104) is configured to remotely monitor the supply current of the semiconductor device (102) via the processor (206).

7. A method of operating the apparatus of claim 1, the method comprising:
determining a current of a semiconductor device (102) in an analog circuit (106) within a process control system via a process control device (104) coupled to the semiconductor device (102), the process control device configured to control a position of a valve in the process control system;
determining, via the process control device (104), an amount of radiation to which the semiconductor device (102) has been exposed based on the current;
comparing, via the process control device (104), the amount of radiation to a radiation dose threshold value, wherein the radiation threshold value corresponds to an amount of radiation at which the analog circuit (106) degrades;
indicating a degradation of the semiconductor device (102) based on the comparison; and
sending an alert to an operator workstation (108) indicating the degradation to prevent the failure of the analog circuit (106) from affecting the process control system.

8. The method of claim 7, further comprising, based on the comparison, sending a warning to an operator workstation (108) that the degradation has occurred.

9. The method of any of the preceding claims 7 or 8, wherein determining the amount of radiation includes using a radiation degradation curve associated with the semiconductor device (102).

10. The method of any of the preceding claims 7 to 9, wherein the radiation degradation curve defines the radiation dose threshold value.

11. The method of claim 7, wherein the process control device (104) remotely determines the current of the semiconductor device (102) via the processor (206).

## Patentansprüche

1. Vorrichtung, aufweisend:
eine Halbleitervorrichtung (102) in einem analogen Schaltkreis (106) für ein Prozesssteuersystem, wobei die Halbleitervorrichtung (102) eine bekannte Verschlechterung in Antwort auf Strahlungs-Ausgesetzt-Sein hat, und
eine Prozesssteuervorrichtung (104), die konfiguriert ist, um eine Position eines Ventils in einem Prozesssteuersystem zu steuern, wobei die Prozesssteuervorrichtung mit der Halbleitervorrichtung (102) verbunden ist und einen Speicher (202), eine Kommunikationsschnittstelle (204) und einen Prozessor (206) aufweist, wobei die Prozesssteuervorrichtung (104) konfiguriert ist, um:
via den Prozessor (206) einen Speisestrom der Halbleitervorrichtung (102) zu überwachen, via den Prozessor (206) den Speisestrom mit einem kumulativen Quantum an Strahlungs-Ausgesetzt-Sein zu korrelieren,
via den Prozessor (206) das Quantum an Strahlungs-Ausgesetzt-Sein mit einem Strahlungsdosisgrenzwert zu vergleichen, wobei der Strahlungsdosisgrenzwert aus der bekannten Verschlechterung abgeleitet ist und zu einem Quantum an Strahlung korrespondiert, bei dem die Halbleitervorrichtung (102) sich verschlechtert, und
via die Kommunikationsschnittstelle (204) einen Alarm an eine Bedienerarbeitsstation (108) zu senden, wenn basierend auf dem Vergleich Verschlechterung angezeigt ist, um zu verhindern, dass das Versagen des analogen Schaltkreises (106) das Prozesssteuersystem beeinträchtigt.

2. Vorrichtung gemäß Anspruch 1, wobei die bekannte Verschlechterung der Halbleitervorrichtung (102) einer Verschlechterungskurve folgt, wobei der Strahlungsdosisgrenzwert durch die Verschlechterungskurve definiert ist oder eine Abnahme des Speisestroms der Halbleitervorrichtung (102) mit einer Zunahme des kumulativen Quantums an Strahlungs-Ausgesetzt-Sein korreliert.

3. Vorrichtung gemäß irgendeinem der Ansprüche 1 oder 2, wobei die Prozesssteuervorrichtung (104) konfiguriert ist, um zu erfassen, dass die Halbleitervorrichtung (102) sich verschlechtert hat, basierend auf dem Vergleich.

4. Vorrichtung gemäß irgendeinem der vorigen Ansprüche, wobei die Halbleitervorrichtung (102) in die Prozesssteuervorrichtung (104) integriert ist oder ein strahlungsharter Mikroleistung-Dual-Operationsverstärker ist.

5. Vorrichtung gemäß Anspruch 1, wobei die Prozesssteuervorrichtung (104) ferner konfiguriert ist, um zu erfassen, dass das Quantum an Strahlungs-Ausgesetzt-Sein sich dem Strahlungsdosisgrenzwert nähert, und um eine Warnung an die Bedienerarbeitsstation (108) zu senden.

6. Vorrichtung gemäß Anspruch 1, wobei die Prozesssteuervorrichtung (104) konfiguriert ist, um den Speisestrom der Halbleitervorrichtung (102) via den Prozessor (206) zu fernüberwachen.

7. Verfahren zum Betreiben der Vorrichtung von Anspruch 1, wobei das Verfahren aufweist:
Ermitteln eines Stroms einer Halbleitervorrichtung (102) in einem analogen Schaltkreis (106) in einem Prozesssteuersystem via eine Prozesssteuervorrichtung (104), die mit der Halbleitervorrichtung (102) verbunden ist, wobei die Prozesssteuervorrichtung konfiguriert ist, um eine Position eines Ventils in dem Prozesssteuersystem zu steuern,
Ermitteln via die Prozesssteuervorrichtung (104) eines Quantums an Strahlung, welchem die Halbleitervorrichtung (102) ausgesetzt worden ist, basierend auf dem Strom,
Vergleichen via die Prozesssteuervorrichtung (104) des Quantums an Strahlung mit einem Strahlungsdosisgrenzwert, wobei der Strahlungsdosisgrenzwert zu einem Quantum an Strahlung korrespondiert, bei welchem sich der analoge Schaltkreis (106) verschlechtert, Anzeigen einer Verschlechterung der Halbleitervorrichtung (102) basierend auf dem Vergleich, und
Senden eines Alarms an eine Bedienerarbeitsstation (108), der die Verschlechterung anzeigt, um zu verhindern, dass das Versagen des analogen Schaltkreises (106) das Prozesssteuersystem beeinträchtigt.

8. Verfahren gemäß Anspruch 7, ferner aufweisend: basierend auf dem Vergleich Senden einer Warnung an eine Bedienerarbeitsstation (108), dass die Verschlechterung aufgetreten ist.

9. Verfahren gemäß irgendeinem der vorigen Ansprüche 7 oder 8, wobei das Ermitteln des Quantums an Strahlung aufweist: Verwenden einer Strahlungsverschlechterungskurve, die mit der Halbleitervorrichtung (102) verknüpft ist.

10. Verfahren gemäß irgendeinem der vorigen Ansprüche 7 bis 9, wobei die Strahlungsverschlechterungskurve den Strahlungsdosisgrenzwert definiert.

11. Verfahren gemäß Anspruch 7, wobei die Prozesssteuervorrichtung (104) via den Prozessor (206) den Strom der Halbleitervorrichtung (102) fernermittelt.

## Revendications

1. Appareil, comprenant :
un dispositif à semi-conducteur (102) dans un circuit analogique (106) pour un système de commande de processus, le dispositif à semi-conducteur (102) présentant une dégradation connue en réponse à une exposition à un rayonnement ; et
un dispositif de commande de processus (104) configuré pour commander une position d'une vanne à l'intérieur du système de commande de processus, le dispositif de commande de processus étant couplé au dispositif à semi-conducteur (102) et comprenant une mémoire (202), une interface de communication (204) et un processeur (206), le dispositif de commande de processus (104) étant configuré pour :
surveiller, via le processeur (206), un courant d'alimentation du dispositif à semi-conducteur (102) ;
corréler, via le processeur (206), le courant d'alimentation avec une quantité cumulée d'exposition à un rayonnement ;
comparer, via le processeur (206), la quantité d'exposition à un rayonnement à un seuil de dose de rayonnement, le seuil de dose de rayonnement étant dérivé de la dégradation connue et correspondant à une quantité de rayonnement à laquelle le dispositif à semi-conducteur (102) se dégrade ; et
envoyer, via l'interface de communication (204), une alerte à un poste de travail d'opérateur (108) lorsqu'une dégradation est indiquée sur la base de la comparaison pour empêcher la défaillance du circuit analogique (106) d'affecter le système de commande de processus.

2. Appareil selon la revendication 1, dans lequel la dégradation connue du dispositif à semi-conducteur (102) suit une courbe de dégradation, dans lequel le seuil de dose de rayonnement est défini par la courbe de dégradation ou corrèle une diminution du courant d'alimentation du dispositif à semi-conducteur (102) avec une augmentation de la quantité cumulée d'exposition à un rayonnement.

3. Appareil selon l'une quelconque des revendications 1 ou 2, dans lequel le dispositif de commande de processus (104) est configuré pour détecter que le dispositif à semi-conducteur (102) s'est dégradé sur la base de la comparaison.

4. Appareil selon l'une quelconque des revendications précédentes, dans lequel le dispositif à semi-conducteur (102) est intégré dans le dispositif de commande de processus (104) ou est un amplificateur opérationnel double de micropuissance durci par rayonnement.

5. Appareil selon la revendication 1, dans lequel le dispositif de commande de processus (104) est en outre configuré pour détecter que la quantité d'exposition à un rayonnement approche du seuil de dose de rayonnement et pour envoyer un avertissement au poste de travail d'opérateur (108).

6. Appareil selon la revendication 1, dans lequel le dispositif de commande de processus (104) est configuré pour surveiller à distance le courant d'alimentation du dispositif à semi-conducteur (102) via le processeur (206).

7. Procédé de fonctionnement de l'appareil selon la revendication 1, le procédé comprenant les étapes consistant à :
déterminer un courant d'un dispositif à semi-conducteur (102) dans un circuit analogique (106) dans un système de commande de processus via un dispositif de commande de processus (104) couplé au dispositif à semi-conducteur (102), le dispositif de commande de processus étant configuré pour commander une position d'une vanne dans le système de commande de processus ;
déterminer, via le dispositif de commande de processus (104), une quantité de rayonnement à laquelle le dispositif à semi-conducteur (102) a été exposé sur la base du courant ;
comparer, via le dispositif de commande de processus (104), la quantité de rayonnement à une valeur de seuil de dose de rayonnement, dans lequel la valeur de seuil de rayonnement correspond à une quantité de rayonnement à laquelle le circuit analogique (106) se dégrade ;
indiquer une dégradation du dispositif à semi-conducteur (102) sur la base de la comparaison ; et
envoyer une alerte à un poste de travail d'opérateur (108) indiquant la dégradation pour empêcher la défaillance du circuit analogique (106) d'affecter le système de commande de processus.

8. Procédé selon la revendication 7, comprenant en outre, sur la base de la comparaison, l'étape consistant à envoyer un avertissement à un poste de travail d'opérateur (108) selon lequel la dégradation s'est produite.

9. Procédé selon l'une quelconque des revendications précédentes 7 ou 8, dans lequel la détermination de la quantité de rayonnement comprend l'utilisation d'une courbe de dégradation par rayonnement associée au dispositif à semi-conducteur (102).

10. Procédé selon l'une quelconque des revendications précédentes 7 à 9 , dans lequel la courbe de dégradation par rayonnement définit la valeur de seuil de dose de rayonnement.

11. Procédé selon la revendication 7, dans lequel le dispositif de commande de processus (104) détermine à distance le courant du dispositif à semi-conducteur (102) via le processeur (206).
